# EUROPEAN PATENT APPLICATION

(11) **EP 2 952 610 A1**
(43) Date of publication of application: **09.12.2015**
(21) Application number: 14746647.8
(22) Date of filing: 30.01.2014
(51) Int. Cl.: C23C 14/34, B32B 9/00, B32B 38/00, C23C 14/06, C23C 14/08, G02B 5/26, G02B 5/28

(54) **PRODUCTION METHOD FOR INFRARED RADIATION REFLECTING FILM**

(30) Priority: 31.01.2013 JP 2013016633; 21.01.2014 JP 2014008874
(71) Applicant: Nitto Denko Corporation, Ibaraki-shi, Osaka 567-8680 (JP)
(72) Inventor: WATANABE, Masahiko, Ibaraki-shi Osaka 567-8680 (JP); OHMORI, Yutaka, Ibaraki-shi Osaka 567-8680 (JP)
(74) Representative: Jones, Helen M.M.
(86) International application number: PCT/JP2014/052132
(87) International publication number: WO 2014/119668

(57) **Abstract**

An infrared reflecting film (100) includes an infrared reflecting layer (20) having a metal layer (25) and a metal oxide layer (21, 22) and a transparent protective layer (30) in this order on a transparent film substrate (10). In the manufacturing method, the metal oxide layer is deposited by a DC sputtering method using a roll-to-roll sputtering apparatus. A sputtering target used in the DC sputtering method contains zinc atoms and tin atoms. The sputtering target is preferably obtained by sintering a metal powder and at least one metal oxide among zinc oxide and tin oxide.

## Description

### TECHNICAL FIELD

The present invention relates to a method for manufacturing an infrared reflecting film which is mainly used for arranging on an interior side of glass windows or the like.

### BACKGROUND ART

Heretofore, an infrared reflecting substrate having an infrared reflecting layer on a substrate of glass, film or the like is known. As the infrared reflecting layer, an alternative laminate of metal layer(s) and metal oxide layer(s) is widely used. The infrared reflecting layer can have a heat shielding property by reflecting near-infrared rays such as sunlight. As the metal layer constituting the infrared reflecting layer, silver or the like is widely used from the viewpoint of enhancing the selective reflectivity of infrared rays. As the metal oxide layer, an indium-tin oxide (ITO), an indium zinc oxide (IZO) or the like is widely used (e.g., Patent Document 1). Attempts have been made to increase the durability of the infrared reflecting substrate by employing zinc tin oxide (ZTO) as a metal oxide layer constituting the infrared reflecting layer (*e.g.,* Patent Document 2 and Patent Document 3).

These metal layers and metal oxide layers often do not have sufficient physical strength such as abrasion-resistance and tend to cause deterioration due to external environment factors such as heat, ultraviolet ray, oxygen, water and chlorine (chloride ions). Thus, in general, a protective layer is provided on the side opposite to the substrate of the infrared reflecting layer for the purpose of protecting the infrared reflecting layer.

### PRIOR ART DOCUMENTS

### PATENT DOCUMENTS

Patent Document 1: WO 2011/109306 A
Patent Document 2: JP 1-301537 A
Patent Document 3: JP 8-171824 A

### SUMMARY OF THE INVENTION

### PROBLEMS TO BE SOLVED BY THE INVENTION

As described above, the infrared reflecting substrate includes a substrate using a rigid substrate such as glass and a substrate using a flexible substrate such as a transparent resin film. Among these substrates, an infrared reflecting film using a flexible substrate is easy to be installed by bonding to window glass or the like. Further, in the infrared reflecting film, it is possible to continuously deposit the metal layer and the metal oxide layer respectively constituting the infrared reflecting layer by using a roll-to-roll sputtering apparatus. In addition, since it is also possible to continuously form a transparent protective layer on the infrared reflecting layer by using a roll coater or the like, the infrared reflecting film using a flexible substrate is excellent in productivity. Particularly, when the metal layer and the metal oxide layer are deposited by a DC sputtering method, which can perform high rate deposition rate, the productivity is largely improved.

However, when the present inventors tried continuous deposition of ITO and IZO by DC sputtering, respectively, which are widely used as a metal oxide layer of the infrared reflecting layer, many particles are generated on the target and abnormal discharge or contamination of the inside of sputtering apparatus resulting from the particles occurs. Therefore it was found that continuously producing a film with stable quality in a long length is difficult. In order to obtain a film with stable quality, it is necessary that deposition operation is periodically interrupted to clean the target or the sputtering apparatus. It takes much time and effort to polish the target surface or to clean the inside of sputtering apparatus. Further, it also takes time to bring the sputtering chamber into vacuum after the cleaning. Thus it was found that ITO and IZO are unsuitable for continuously producing a long film.

On the other hand, in the ZTO used as a metal oxide in Patent Documents 2 and 3, the electrical conductivity of an oxide target is low, particularly in an Sn-rich ZTO in which tin content is large, and thus it is difficult to perform the deposition stably for a long time by a DC sputtering method. Further, when a metal oxide layer composed of ZTO is deposited by a reactive sputtering method using a metal target composed of a metal zinc and a metal tin, a metal layer (Ag, etc.) serving as a deposition underlay of ZTO is oxidized by excessive oxygen in a deposition atmosphere and characteristics of the infrared reflecting layer are deteriorated. In addition, when a rigid substrate such as a glass substrate is used, it is possible to employ a method in which an alloy layer of zinc and tin is deposited by a DC sputtering method followed by oxidation at high temperatures to form ZTO, but when a transparent resin film substrate is used as a substrate, there is a problem that the film substrate is melted or thermally-deteriorated due to the treatment at high temperature.

As described above, a method of continuously producing the metal oxide layer constituting the infrared reflecting layer stably for a long time by DC sputtering on the transparent film substrate, is not yet established, and under present circumstances, there are points to be improved for improvement of the production efficiency and characteristics of the infrared reflecting film.

### MEANS FOR SOLVING THE PROBLEMS

In view of the above-mentioned current situation, the present inventors made investigations and consequently found that when ZTO is deposited by DC sputtering by using a target formed by sintering a metal oxide and a metal powder, characteristics of the infrared reflecting film are good. It was also found that abnormal discharge or contamination of the inside of sputtering apparatus hardly occurs, thereby allowing a continuous production of the film operated stably for a long time, compared with the case of depositing ITO or IZO.

The present invention relates to a method for manufacturing an infrared reflecting film including an infrared reflecting layer having a metal layer and a metal oxide layer, and a transparent protective layer in this order on a transparent film substrate. In the manufacturing method of the present invention, the metal oxide layer constituting the infrared reflecting layer is deposited by a DC sputtering method using a roll-to-roll sputtering apparatus. In the DC sputtering, a sputtering target containing zinc atoms and tin atoms is used. The sputtering target is a target formed by sintering a metal powder and at least one metal oxide among zinc oxide and tin oxide.

A metal powder used for the formation of the target preferably contains metal zinc and/or metal tin. A total of the contents of the metal zinc and the metal tin respectively used for the formation of the target is preferably 0.1 to 20 wt%. A ratio between zinc atoms and tin atoms, respectively contained in the target, is preferably within the range of 10 : 90 to 60 : 40 in terms of an atomic ratio.

In a preferable embodiment of the present invention, deposition of the metal oxide layer is continuously performed to a length of 6000 nm • m or more in terms of the product of a deposition thickness and a length (a cross-section area in MD).

### EFFECTS OF THE INVENTION

In the present invention, ZTO is deposited as a metal oxide layer constituting the infrared reflecting layer by a DC sputtering method using a predetermined target, thereby suppressing a particle generation on the target surface, compared with the case where ITO or IZO is deposited. Thus, the metal oxide layer can be continuously deposited stably without cleaning the target and the sputtering apparatus and the productivity of the infrared reflecting film can be increased.

### BRIEF DESCRIPTION OF THE DRAWINGS

FIG. 1 is a schematic cross-sectional view showing a stacking configuration of an infrared reflecting film of an embodiment.
FIG. 2 is a schematic cross-sectional view showing a usage example of an infrared reflecting film.
FIGS. 3 (A) to (C) are graphs each showing the number of times of abnormal discharge occurred during metal oxide layer deposition in Examples and Comparative Examples, plotted with respect to a deposition amount.
FIGS. 4 (A) to (C) are photographs each showing a state in which the particles adhered to a target surface after continuously depositing a metal oxide layer in Examples and Comparative Examples.

### MODE FOR CARRYING OUT THE INVENTION

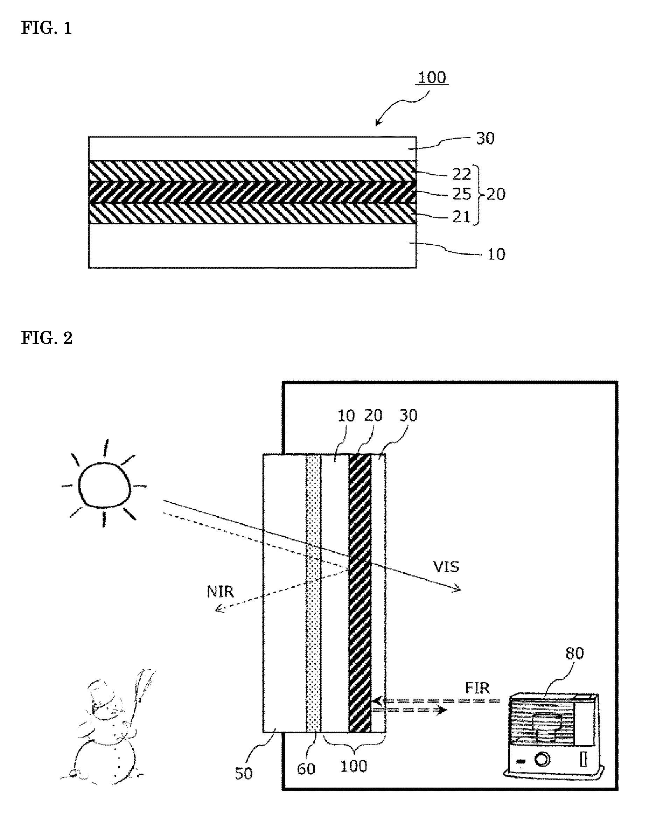

FIG. 1 is a schematic cross-sectional view showing a configuration example of an infrared reflecting film. As shown in FIG. 1, an infrared reflecting film 100 includes an infrared reflecting layer 20 and a transparent protective layer 30 in this order on one principal surface of a transparent film substrate 10.

### [Transparent Film Substrate]

As the transparent film substrate 10, a flexible transparent film is used. As the transparent film substrate, a film having visible light transmittance of 80% or more is suitably used. The visible light transmittance is measured according to JIS A 5759-2008 (Adhesive films for glazings).

The thickness of the transparent film substrate 10 is not particularly limited. Thickness range of about 10 µm to 300 µm is suitable. Further, since there may be cases where high temperature processes are performed in formation of the infrared reflecting layer 20 on the transparent film substrate 10, a resin material constituting the transparent film substrate preferably has excellent heat resistance. Examples of the resin material constituting the transparent film substrate include polyethylene terephthalate (PET), polyethylene naphthalate (PEN), polyether ether ketone (PEEK), polycarbonate (PC) and the like.

A hard coat layer may be disposed on the surface on an infrared reflecting layer 20 formation side of the transparent film substrate 10, for the purpose of increasing the mechanical strength of the infrared reflecting film. For the purpose of increasing the adhesion to the infrared reflecting layer 20, etc., the surface of the transparent film substrate 10 or the surface of the hard coat layer may be subjected to a surface modification treatment such as corona treatment, plasma treatment, flame treatment, ozone treatment, primer treatment, glow treatment, saponification treatment, or treatment with a coupling agent.

### [Infrared Reflecting Layer]

The infrared reflecting layer 20 has a property of transmitting visible light and reflecting infrared rays, and includes a metal layer and a metal oxide layer. In general, the infrared reflecting layer 20, as shown in FIG. 1, has a configuration in which the metal layer 25 is sandwiched between the metal oxide layers 21 and 22. Although illustrated in FIG. 1 is an infrared reflecting layer 20 having a three-layer structure in which one metal layer 25 is sandwiched between two metal oxide layers 21 and 22, the infrared reflecting layer may have a five-layer structure, for example, metal oxide layer / metal layer / metal oxide layer / metal layer / metal oxide layer. When the number of stacked layers is increased more, for example, five-layer, seven-layer, nine-layer, ..., the wavelength selectivity of the reflectance can be enhanced to increase the reflectance of the near-infrared rays to provide a heat shielding property, and the transmittance of visible light can be increased. On the other hand, from the viewpoint of increasing the productivity, the infrared reflecting layer preferably has a three-layer structure as shown in FIG. 1.

The infrared reflecting layer 20 may include another metal layer, metal oxide layer or the like between the metal layer 25 and the metal oxide layers 21, 22, for the purpose of, for example, improving the adhesion between the metal layer 25 and the metal oxide layers 21, 22 or imparting the durability to the metal layer. The infrared reflecting layer 20 may have a configuration other than the alternative laminate of the metal oxide layer and the metal layer as long as the infrared reflecting layer 20 includes at least one metal layer and one metal oxide layer. It is preferred that at least one metal oxide layer 22 is formed on a transparent protective layer 30 side of the metal layer 25.

### <Metal Layer>

The metal layer 25 plays a central role in reflecting infrared rays. As a material for the metal layer 25, a metal such as Au, Ag, Cu and Al or an alloy of two or more of these metals. Among these, a metal layer composed mainly of silver is suitably used as the metal layer 25 from the viewpoint of increasing visible light transmittance and an infrared reflectance. Since silver has a high free electron density, it can realize a high reflectance of near-infrared rays and far-infrared rays, and therefore it is possible to attain an infrared reflecting film which is excellent in the heat shielding effect and the heat insulating effect even when the number of stacked layers constituting the infrared reflecting layer 20 is small.

The content of silver in the metal layer 25 is preferably 90 wt% or more, more preferably 93 wt% or more, further preferably 95 wt% or more, and particularly preferably 96 wt% or more. The wavelength selectivity of the transmittance and the reflectance can be enhanced and the visible light transmittance of the infrared reflecting film can be increased by increasing the content of silver in the metal layer.

The metal layer 25 may be a silver alloy layer containing metal other than silver. For example, in order to increase the durability of the metal layer, a silver alloy may be used. As the metal added for the purpose of increasing the durability of the metal layer, palladium (Pd), gold (Au), copper (Cu), bismuth (Bi), germanium (Ge), gallium (Ga) and the like are preferred. Among these metals, Pd is most suitably used from the viewpoint of imparting high durability to silver. When an addition amount of Pd or the like is increased, the durability of the metal layer tends to increase. When the metal layer 25 contains metal such as Pd other than silver, the content of the metal is preferably 0.1 wt% or more, more preferably 0.3 wt% or more, further preferably 0.5 wt% or more, and particularly preferably 1 wt% or more. On the other hand, when the addition amount of Pd or the like is increased and the content of silver is decreased, the visible light transmittance of the infrared reflecting film tends to decrease. Therefore, the content of metal other than silver in the metal layer 25 is preferably 10 wt% or less, more preferably 7 wt% or less, further preferably 5 wt% or less, and particularly preferably 4 wt% or less.

The thickness of the metal layer 25 is appropriately set in consideration of a refractive index of the metal material, and a refractive index and a thickness of the metal oxide layer so that the infrared reflecting layer transmits visible light and selectively reflects near-infrared rays. The thickness of the metal layer 25 may be set, for example, within the range of 3 nm to 50 nm. The method for forming the metal layer is not particularly limited. Deposition by a dry process such as a sputtering method, a vacuum deposition method, a CVD method or an electron-beam deposition method, is preferred. Particularly, in the present invention, it is preferred to deposit the metal layer by a DC sputtering method using a roll-to-roll sputtering apparatus, as with a deposition of the metal oxide layer described later.

### <Metal Oxide Layer>

The metal oxide layers 21 and 22 are disposed for the purpose of controlling an amount of reflected visible light at an interface between the metal oxide layer and the metal layer 25 to achieve high visible light transmittance and high infrared reflectance simultaneously. Further, the metal oxide layer can also serve as a protective layer for preventing degradation of the metal layer 25. From the viewpoint of enhancing the wavelength selectivity of transmission and reflection in the infrared reflecting layer, the refractive indices of the metal oxide layers 21, 22 for visible light are preferably 1.5 or more, more preferably 1.6 or more, and further preferably 1.7 or more. Examples of a material having the above-mentioned refractive index include oxides of metals such as Ti, Zr, Hf, Nb, Zn, Al, Ga, In, Tl, Ga and Sn, or composite oxides of these metals.

In the present invention, as at least one metal oxide layer, a composite metal oxide (ZTO) containing zinc oxide and tin oxide is formed. When the infrared reflecting layer 20 includes two or more metal oxide layers, at least one layer is composed of ZTO and other metal oxide layers may be composed of a metal oxide other than ZTO. It is preferred that ZTO is deposited as all metal oxide layers, from the viewpoint of increasing the productivity of the infrared reflecting layer. ZTO is excellent in chemical stability (durability to acid, alkali and chloride ions) and excellent in the adhesion to resin materials or the like constituting a transparent protective layer 30 described later. Therefore the metal oxide layer 22 and the transparent protective layer 30 can function synergistic to enhance the effect of protecting the metal layer 25.

The metal oxide layer is deposited by a DC sputtering method using a roll-to-roll sputtering apparatus. When a roll-to-roll sputtering apparatus is used, a continuous deposition in long length can be attained. Further, since a deposition rate of DC sputtering method is high, it is possible to improve the productivity of the infrared reflecting film.

For depositing the metal oxide layer, a target containing zinc atoms and tin atoms and formed by sintering a metal powder and at least one metal oxide among zinc oxide and tin oxide, is used. When a material for forming the target contains zinc oxide and does not contain tin oxide, a metal tin powder is contained in the material for forming the target. When the material for forming the target contains tin oxide and does not contain zinc oxide, a metal zinc powder is contained in the material for forming the target. When the material for forming the target contains both of zinc oxide and tin oxide, a metal powder in the material for forming the target may be a powder of metal other than metal zinc and metal tin; however, the material for forming the target preferably contains at least any one among metal zinc and metal tin, and particularly preferably contains metal zinc.

Zinc oxide and tin oxide (particularly, tin oxide) have low electrical conductivity, and thus a ZTO target formed by sintering only metal oxides has low electrical conductivity. In DC sputtering using such a target, there is a tendency that discharge does not occur or performing deposition stably for a long time is difficult. In contrast, since a target formed by sintering a metal oxide and a metal powder is used in the present invention, the electrical conductivity of the target is improved to stabilize discharge during DC sputtering deposition.

When the amount of a metal used for the formation of the sputtering target is excessively small, sufficient electrical conductivity is not imparted to the target, and therefore deposition by DC sputtering may become unstable. On the other hand, when the content of a metal in the target is excessively large, the amount of a remaining metal unoxidized during the sputtering deposition or the amount of a metal oxide whose oxygen content is less than the stoichiometric composition is increased, and this tends to cause a reduction of visible light transmittance. When the oxygen introduction amount during deposition is increased for the purpose of oxidizing the remaining metal or the metal oxide whose oxygen content is less than the stoichiometric composition, a metal layer (silver, etc.) serving as an underlay for deposition of the metal oxide layer may be oxidized to cause deterioration of infrared-ray reflection characteristics or visible light transmittance. From the above-mentioned viewpoints, the amount of the metal used for the formation of the sputtering target is preferably 0.1 to 20 wt%, more preferably 0.2 to 15 wt%, further preferably 0.5 to 13 wt%, and particularly preferably 1 to 12 wt% in the material for forming a target. Since the metal powder used as a material for the formation of the target is oxidized by sintering, the metal powder may exist as a metal oxide in a sintered target.

In addition, when the ZTO is deposited by DC sputtering using the above-mentioned target, there is an advantage that a particle generation (adhesion) on the target during continuous deposition is less than the case of depositing ITO or IZO as a metal oxide. If particles adhere to the surface of the target, abnormal discharge or contamination inside the sputtering apparatus occurs, so that a film with stable quality is unable to be obtained. Therefore, when particles adhere to the surface of the target, deposition operation is once stopped, and maintenance work such as polishing of the target surface or cleaning of sputtering apparatus, is required. Further, it also takes time to bring the sputtering chamber into vacuum in restarting deposition after the maintenance.

In the present invention, by depositing the ZTO by sputtering using a predetermined target, the adhesion of particles to the target surface during deposition is suppressed and thus a maintenance interval is lengthened (maintenance frequency is reduced), so that the production efficiency of the infrared reflecting film can be significantly improved. As for a continuous deposition length by roll-to-roll sputtering, the longer, the better. In the present invention, the deposition can be continuously performed, for example, to a length of 6000 nm • m or more in terms of the product of a deposition thickness and a length (a cross-section area in MD) of the metal oxide layer since the maintenance frequency of the sputtering apparatus can be reduced.

A ratio between zinc atoms (Zn) and tin atoms (Sn), respectively contained in the sputtering target used for the deposition of the metal oxide layer, is preferably in the range of 10 : 90 to 60 : 40 in terms of an atomic ratio. The ratio between Zn and Sn is more preferably in the range of 15 : 85 to 50 : 50, and further preferably in the range of 20 : 80 to 40 : 60. By setting the content of Zn to 10 atom% or more with respect to 100 atom% as a total of Sn and Zn, the electrical conductivity of the target is increased to enable the deposition by DC sputtering, and therefore the productivity of the infrared reflecting film can be further increased. From the viewpoint of improving a deposition property, volume resistivity of the target is preferably 1000 mΩ• cm or less, more preferably 500 mΩ• cm or less, further preferably 300 mΩ• cm or less, particularly preferably 150 mΩ• cm or less, and most preferably 100 mΩ• cm or less.

On the other hand, when the content of Zn is excessively large and the content of Sn is relatively small, this may cause a reduction of the durability of the infrared reflecting layer or a reduction of the adhesion to the metal layer. Therefore, the content of Zn atoms in the target is preferably 60 atom% or less with respect to 100 atom% as a total of Sn and Zn. Zinc atoms contained in the sputtering target are derived from zinc atoms in zinc oxide and the metal zinc powder. Tin atoms contained in the sputtering target are derived from tin atoms in tin oxide and the metal tin powder.

In the present invention, by depositing Sn-rich ZTO in which the content of Sn is large as the metal oxide layer, the adhesion between the metal layer and the metal oxide layer is enhanced and the durability of the infrared reflecting layer is improved. Therefore, the content of Sn in the sputtering target is preferably 40 atom% or more, more preferably 50 atom% or more, and further preferably 60 atom% or more with respect to 100 atom% as a total of Sn and Zn. Although the Sn-rich ZTO tends to become low in electrical conductivity, a target formed by sintering a metal oxide and a metal powder as described above is used in the present invention so that the electrical conductivity of the target is improved, and thus Sn-rich ZTO can be deposited by DC sputtering.

The sputtering target used for the deposition of the metal oxide layer may contain metals such as Ti, Zr, Hf, Nb, Al, Ga, In and Tl, or metal oxides thereof in addition to zinc, tin and oxides thereof. However, an increase in the content of a metal atom other than zinc and tin may cause a reduction of the durability of the infrared reflecting layer or deterioration of transparency. Therefore, the total of the contents of zinc atoms and tin atoms in the sputtering target used for deposition of the metal oxide layer is preferably 97 atom% or more, and more preferably 99 atom% or more with respect to 100 atom% as a total of metals in the sputtering target.

In the sputtering deposition using the above-mentioned target, it is preferred that at first, inside of the sputtering chamber is evacuated to bring the inside of sputtering apparatus into an atmosphere in which impurities such as water and organic gas generated from the substrate are removed.

After the evacuation, sputtering deposition is performed while introducing an inert gas such as Ar, and oxygen into the sputtering chamber. The amount of oxygen introduced into the deposition chamber is preferably 8 vol% or less, more preferably 5 vol% or less, and further preferably 4 vol% or less with respect to the total flow rate of the introduced gas. When the oxygen introduction amount is large, the metal layer serving as an underlay of the metal oxide layer is easily oxidized. The oxygen introduction amount refers to an amount (vol%) of oxygen introduced into a deposition chamber, in which a target to be used for deposition of the metal oxide layer is placed, with respect to the total amount of the gas introduced into the deposition chamber. When a sputtering deposition apparatus including a plurality of deposition chambers divided by a closure plate is employed, the oxygen introduction amount is calculated based on the amount of gas introduced into each divided deposition chamber.

In the sputtering deposition using the above target, a small oxygen introduction amount tends to produce a metal oxide whose oxygen content is less than the stoichiometric composition. In the present invention, by depositing a metal oxide layer by sputtering at a low oxygen concentration, a metal oxide having insufficient oxygen in which the oxygen content is less than the stoichiometric composition can exists in the layer to improve the adhesion between the metal layer and the metal oxide layer.

On the other hand, when the oxygen introduction amount during sputtering deposition is excessively small, an amount of the metal oxide having insufficient oxygen increases, and this tends to cause a reduction of visible light transmittance. Therefore, the amount of oxygen introduced into the deposition chamber during sputtering deposition is preferably 0.1 vol% or more, more preferably 0.5 vol% or more, and further preferably 1 vol% or more with respect to the total flow rate of the introduced gas.

A substrate temperature during deposition of the metal oxide layer by sputtering is preferably lower than a heatresistant temperature of the transparent film substrate. The substrate temperature is preferably, for example, 20°C to 160°C, and more preferably 30°C to 140°C. A power density during sputtering deposition is preferably, for example, 0.1 W/cm² to 10 W/cm², more preferably 0.5 W/cm² to 7.5 W/cm², and further preferably 1 W/cm² to 6 W/cm². A process pressure during deposition is preferably, for example, 0.01 Pa to 10 Pa, more preferably 0.05 Pa to 5 Pa, and further preferably 0.1 Pa to 1 Pa. When the process pressure is excessively high, a deposition rate tends to decrease, and in contrast, when the pressure is excessively low, discharge tends to be unstable.

The thicknesses of the metal oxide layers 21 and 22 are appropriately set in consideration of a refractive index and a thickness of the metal layer, and the number of stacked layers of the infrared reflecting layer so that the infrared reflecting layer 20 transmits visible light and selectively reflects near-infrared rays. The thicknesses of the metal oxide layers can be adjusted, for example, within the range of about 3 nm to 100 nm, preferably within the range of about 5 nm to 80 nm.

The contents of zinc oxide and tin oxide in the metal oxide layer is determined according to the composition of the target. A weight ratio between the zinc oxide and the tin oxide in the ZTO metal oxide layer is preferably 7 : 93 to 50 : 50, more preferably 10 : 90 to 45 : 55, and further preferably 15 : 85 to 40 : 60.

### [Transparent Protective Layer]

A transparent protective layer 30 is provided on the infrared reflecting layer 20 for the purpose of preventing the abrasion or degradation of the metal oxide layers 21 and 22 and metal layer 25. Although material and configuration of the transparent protective layer 30 is not particularly limited, one having a high visible light transmittance is preferably used. In addition, the far-infrared absorptivity of the transparent protective layer 30 is preferably low, from the viewpoint of enhancing the heat insulating effect by the infrared reflecting film. When the far-infrared absorption by the transparent protective layer 30 is high, heat insulating properties of the infrared reflecting film tends to decrease since far-infrared rays from the indoor are absorbed in the transparent protective layer and dissipated outdoors due to thermal conduction. On the other hand, when the far-infrared absorption by the transparent protective layer 30 is low, the far-infrared rays are reflected indoors by the metal layer 25 of the infrared reflecting layer 20. Therefore, when the far-infrared absorptivity is lower, the heat insulating effect by the infrared reflecting film is higher.

When the thickness of the transparent protective layer is reduced to decrease the far-infrared absorptivity, the thickness of the transparent protective layer is preferably 20 to 500 nm, more preferably 25 to 200 nm, further preferably 30 to 150 nm, particularly preferably 40 to 110 nm, and most preferably 45 to 100 nm. When the thickness of the transparent protective layer is excessively large, heat insulating properties of the infrared reflecting film tend to decrease since an amount of the far-infrared rays absorbed in the transparent protective layer increases. When an optical thickness of the transparent protective layer overlaps with a wavelength range of visible light, an iris phenomenon occurs due to the interference by multiple reflections at an interface. Also from this viewpoint, the thickness of the transparent protective layer is preferably small. In the present invention, ZTO which is excellent in the mechanical strength and chemical strength is used as materials of the metal oxide layers 21, 22 of the infrared reflecting layer 20, and thus an infrared reflecting film having excellent durability can be attained even when the thickness of the transparent protective layer is 200 nm or less.

When the thickness of the transparent protective layer is small, while the heat insulating effect can be enhanced by a reduction of the far-infrared absorptivity, a function as the protective layer to the infrared reflecting layer may be deteriorated. Therefore, the thickness of the transparent protective layer is preferably 20 nm or more, and more preferably 30 nm or more. Further, when the thickness of the transparent protective layer is reduced to tens of nm to hundreds of nm, it is preferred that a material having excellent mechanical strength and excellent chemical strength is used as a material of the transparent protective layer for increasing the durability of the infrared reflecting layer itself. Examples of the method of increasing the durability of the infrared reflecting layer itself include a method of increasing the content of a component such as palladium in the metal layer 25 as described above. For example, when the metal layer 25 is an alloy of silver and palladium and a weight ratio between silver and palladium is set to preferably about 90 : 10 to 98 : 2, more preferably about 92 : 8 to 97 : 3, and further preferably about 93 : 7 to 96 : 4, the deterioration of the metal layer 25 can be prevented and the durability of the infrared reflecting film can be increased even when the thickness of the transparent protective layer 30 is small.

When the thickness of the transparent protective layer 30 is made small, *e.g.,* 200 nm or less, to reduce far-infrared absorption, a material thereof preferably has high visible light transmittance, and excellent mechanical strength and excellent chemical strength. For example, active ray-curable or thermosetting organic resins such as fluorine-based, acryl-based, urethane-based, ester-based, epoxy-based and silicone-based resins; inorganic materials such as silicon oxide, silicon nitride, silicon oxynitride, aluminum oxide, titanium oxide, zirconium oxide and sialon (SiAlON); or organic-inorganic hybrid materials in which an organic component is chemically coupled with an inorganic component are preferably used.

When an organic material or an organic-inorganic hybrid material is employed as a material of the transparent protective layer 30, it is preferred to introduce a cross-linked structure. When the cross-linked structure is formed in the transparent protective layer 30, mechanical strength and chemical strength of the transparent protective layer are increased, and a function of protecting the infrared reflecting layer is increased. Among others, it is preferred to introduce a cross-linked structure derived from an ester compound having an acid group and a polymerizable functional group in a molecule.

Examples of the ester compound having an acid group and a polymerizable functional group in a molecule include esters of polyhydric acids such as phosphoric acid, sulfuric acid, oxalic acid, succinic acid, phthalic acid, fumaric acid and maleic acid; with a compound having, in a molecule, a hydroxyl group and a polymerizable functional group such as ethylenic unsaturated groups, silanol groups or epoxy groups. Although the ester compound may be a polyhydric ester such as diester or triester, it is preferred that at least one of the acid group in the polyhydric acid is not esterified.

When the transparent protective layer 30 has a cross-linked structure derived from the above-mentioned ester compound, mechanical strength and chemical strength of the transparent protective layer are increased and the adhesion between the transparent protective layer 30 and the infrared reflecting layer 20 is enhanced, thereby further improving the durability. Among the above ester compounds, an ester compound of phosphoric acid and an organic acid (phosphate ester compound) having a polymerizable functional group is preferred to increase the adhesion between the transparent protective layer and the metal oxide layer. It is estimated that an improvement of the adhesion between the transparent protective layer and the metal oxide layer is derived from the fact that an acid group in the ester compound exhibits high compatibility with a metal oxide, and in particular, a hydroxyl group of phosphoric acid in the phosphate ester compound has excellent compatibility with a metal oxide layer, thereby improving the adhesion.

From the viewpoint of enhancing mechanical strength and chemical strength of the transparent protective layer 30, the above ester compound preferably contains a (meth)acryloyl group as the polymerizable functional group. Further, from the viewpoint of facilitating introduction of the cross-linked structure, the above ester compound may have a plurality of functional groups in the molecule. As the above ester compound, for example, a phosphate monoester compound or a phosphate diester compound represented by the following formula (1) is suitably used. The phosphate monoester may be used in combination with the phosphate diester.

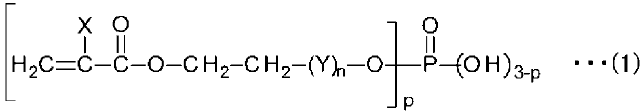

In the above formula, X represents a hydrogen atom or a methyl group, and (Y) represents a -OCO(CH₂)₅- group. n is 0 or 1, and p is 1 or 2.

The content of the structure derived from the above ester compound in the transparent protective layer is preferably 1 to 40 wt%, more preferably 1.5 to 30 wt%, further preferably 2 to 20 wt%, and particularly preferably 2.5 to 17.5 wt%. In a particularly preferable embodiment, the content of the structure derived from the above ester compound in the transparent protective layer is 2.5 to 15 wt%, or 2.5 to 12.5 wt%. When the content of the structure derived from the ester compound is excessively small, the effect of improving the strength or the adhesion may not be adequately achieved. On the other hand, when the content of the structure derived from the ester compound is excessively large, a curing rate during formation of the transparent protective layer may be low, resulting in a reduction of the hardness of the layer, or slip properties of the surface of the transparent protective layer may be deteriorated, resulting in a reduction of abrasion-resistance. The content of the structure derived from the ester compound in the transparent protective layer can be set to a desired range by adjusting the content of the above ester compound in a composition in formation of the transparent protective layer. In other words, when a material for forming the transparent protective layer contains a phosphate ester compound in an amount of preferably 1 to 40 wt%, more preferably 1.5 to 30 wt%, further preferably 2 to 20 wt%, and particularly preferably 2.5 to 17.5 wt% as a solid content, the structure derived from the ester compound can be introduced into the transparent protective layer in a specific amount. In a particularly preferable embodiment, the content of the phosphate ester compound in the material for forming the transparent protective layer is 2.5 to 15 wt%, or 2.5 to 12.5 wt%.

In addition to the method in which the thickness of the transparent protective layer 30 is reduced to tens of nm to hundreds of nm, the far-infrared absorptivity can also be reduced to enhance the heat insulating properties of the infrared reflecting film by a method in which a material having low far-infrared absorptivity is used as a material constituting the transparent protective layer 30. According to this embodiment, the durability of the infrared reflecting film can be enhanced without increasing the content of palladium in the metal layer 25 constituting the infrared reflecting layer 20. Therefore, this embodiment is preferred in increasing the visible light transmittance of the infrared reflecting film.

As the material having low far-infrared absorptivity, a compound in which the content of a C=C bond, a C=O bond, a C-O bond and an aromatic ring is low, is suitably used, and for example, polyolefins such as polyethylene and polypropylene; alicyclic polymers such as cycloolefin-based polymer; and rubber-based polymer are suitably used.

As the material constituting the transparent protective layer, one having excellent adhesion to the infrared reflecting layer and excellent abrasion-resistance, as well as low far-infrared absorptivity, is suitably used. From such a viewpoint, rubber-based materials are particularly preferred, and among these materials, nitrile rubber-based materials are suitably used. The nitrile rubber-based material contains structures represented by the following formulas (A), (B) and (C) in its molecule.

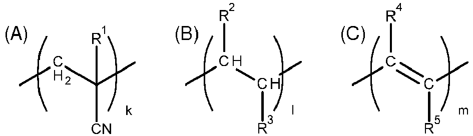

In the above-mentioned formulas (A) to (C), R¹ is hydrogen or a methyl group, and R² to R⁵ independently represent hydrogen, a linear or branched alkyl group having 1 to 4 carbon atoms or a linear or branched alkenyl group having 1 to 4 carbon atoms. Particularly, a nitrile rubber, in which all of R¹ to R⁵ in the formulas (A) to (C) are hydrogen, has excellent transparency and excellent durability. Therefore the nitrile rubber is suitable as a material of the transparent protective layer.

The nitrile rubber is obtained by, for example, copolymerizing acrylonitrile and/or a derivative thereof with 1,3-butadiene. Particularly, a hydrogenated nitrile rubber (HNBR) obtained by hydrogenating (hydrogen addition of) a part of or all of double bonds contained in the nitrile rubber, is suitably used as the material of the transparent protective layer. When the double bond is hydrogenated, the far-infrared absorptivity is reduced to decrease the far-infrared absorptivity of the transparent protective layer and thus heat insulating properties of the infrared reflecting film can be increased.

When a hydrogenated nitrile rubber is used as a material of the transparent protective layer, a molar ratio for the contents of the structural units represented by the above-mentioned formulas (A), (B) and (C) is preferably k : l : m = 3 to 30 : 20 to 95 : 0 to 60 (sum of k, l and m is 100). The ratio of k : l : m (molar ratio) is more preferably 5 to 25 : 60 to 90 : 0 to 20, and further preferably 15 to 25 : 65 to 85 : 0 to 10. By adjusting the ratio of k : l : m (molar ratio) to the above-mentioned range, a transparent protective layer having low far-infrared absorption and excellent in hardness and adhesion can be formed.

In a case where the material having low far-infrared absorptivity, such as a hydrogenated nitrile rubber, is used as the material of the transparent protective layer 30, it is also preferred that a cross-linked structure is introduced into a polymer chain from the viewpoint of increasing physical strength and durability such as solvent resistance of the transparent protective layer 30. The cross-linked structure can be introduced by reacting a polymer formed by polymerization with a crosslinker. As the crosslinker, radical polymerizable multi-functional monomers are suitably used, and particularly multi-functional (meth)acryl-based monomers are preferably used. Examples of the multi-functional (meth)acryl-based monomer used as the crosslinker include trimethylolpropane tri(meth)acrylate, tris(acryloxyethyl)isocyanurate, ditrimethylolpropane tetra(meth)acrylate, pentaerythritol tetra(meth)acrylate, dipentaerythritol penta(meth)acrylate, dipentaerythritol hexa(meth)acrylate, and the like.

An addition amount of the crosslinker is preferably about 1 to 35 parts by weight, and more preferably about 2 to 25 parts by weight with respect to 100 parts by weight of a polymer such as a hydrogenated nitrile rubber. When the content of the crosslinker is excessively small, durability may not be adequately improved. Further, when the content of the crosslinker is excessively large, far-infrared rays absorbed by the crosslinker is increased to increase the far-infrared absorption by the protective layer, and therefore the heat insulating properties of the infrared reflecting film may be deteriorated.

A method of forming the transparent protective layer 30 is not particularly limited. For example, when the thickness of the transparent protective layer is reduced to tens of nm to hundreds of nm, a solution, which is formed by dissolving monomer or an oligomer of an organic resin material and/or a precursor of an organic-inorganic hybrid material, and the crosslinker such as the above-mentioned ester compound as required in a solvent, is used. When a material having small far-infrared absorption such as a hydrogenated nitrile rubber is used as the material of the transparent protective layer, a solution formed by dissolving a polymer material and a crosslinker as required in a solvent is used.

A solvent to be used for preparation of these solutions is not particularly limited as long as the above-mentioned material can be dissolved by the solvent. For example, a low-boiling point solvent such as methyl ethyl ketone (MEK) or methylene chloride is suitably used. Further, the solution for forming the transparent protective layer may include additives such as coupling agents (silane coupling agent, titanium coupling agent, etc.), leveling agents, ultraviolet absorbers, antioxidants, heat stabilizers, lubricants, plasticizers, coloring inhibitors, flame retarders and antistatic agents in addition to the polymer, the monomer and the crosslinker. The contents of these additives can be appropriately adjusted to an extent which does not impair the object of the present invention.

The transparent protective layer can be formed by a method in which the above-mentioned solution is applied onto the infrared reflecting layer and the solvent is removed by evaporation. Curing of a polymer or introduction of the cross-linked structure is preferably performed by irradiating of active rays or providing heat energy after removing the solvent. Particularly, from the viewpoint of improving the productivity or preventing thermal deterioration of the film substrate, it is preferred to perform curing of a polymer or introduction of the cross-linked structure by irradiation of active rays such as ultraviolet rays and electron beams.

An indentation hardness of the transparent protective layer 30 is preferably 1.2 MPa or more, from the viewpoint of enhancing the abrasion-resistance of the infrared reflecting film to secure the function of protecting the infrared reflecting layer. The indentation hardness can be adjusted within the above-mentioned range by introducing the cross-linked structure into a material constituting the transparent protective layer 30 as described above, or the like. The indentation hardness of the transparent protective layer is measured by an indentation test using a microhardness testing machine. In indentation measurement, an indentation load P of an indenter, and a projected area A of a contact region (projected contact area) of the indenter with the protective layer is measured in a state in which the indenter is pressed into a predetermined depth of the protective layer. The indentation hardness H is calculated based on the formula, H = P/A. The projected contact area A can be measured by the method disclosed in JP 2005 -195357 A.

### [Stacking Configuration of Infrared Reflecting Film]

As described above, the infrared reflecting film 100 of the present invention includes the infrared reflecting layer 20 having the metal layer and the metal oxide layer, and the transparent protective layer 30 on one principal surface of the transparent film substrate 10. A hard coat layer or an easily adhesive layer may be disposed between the transparent film substrate 10 and the infrared reflecting layer 20 or between the infrared reflecting layer and the transparent protective layer, for the purpose of increasing the adhesion between the respective layers or increasing the strength of the infrared reflecting film. Although materials and formation methods of the easily adhesive layer, hard coat layers or the like are not particularly limited, transparent materials having high visible light transmittance are suitably used.

FIG. 2 is a schematic cross-sectional view showing a type of usage of the infrared reflecting film 100. In FIG. 2, a transparent film substrate 10 side of the infrared reflecting film 100 is bonded to a window 50 with an appropriate adhesive layer 60 interposed therebetween. In this type of usage, a transparent protective layer 30 is arranged on an interior side of the window.

When the infrared reflecting film is used in an embodiment shown in FIG. 2, an adhesive layer or the like may be provided on a surface opposite to the infrared reflecting layer 20 of the transparent film substrate 10 for bonding the infrared reflecting film to window glass or the like. As the adhesive layer, an adhesive having high visible light transmittance and a small difference in refractive index with the transparent film substrate 10 is suitably used. For example, an acryl-based pressure sensitive adhesive is suitable as a material of the adhesive layer provided for the transparent film substrate, since it has excellent optical transparency, exhibits appropriate wettability, cohesive property, and adhesion properties, and is excellent in weatherability and heat resistance.

The adhesive layer preferably has high visible light transmittance and low ultraviolet transmittance. The degradation of the infrared reflecting layer caused by ultraviolet rays of the sunlight or the like can be suppressed by reducing the ultraviolet transmittance of the adhesive layer. From the viewpoint of reducing the ultraviolet transmittance of the adhesive layer, the adhesive layer preferably contains an ultraviolet absorber. The degradation of the infrared reflecting layer caused by ultraviolet rays from the outdoors can also be suppressed by using a transparent film substrate containing an ultraviolet absorber. An exposed surface of the adhesive layer is preferably temporarily attached with a separator to be covered for the purpose of preventing the contamination of the exposed surface until the infrared reflecting film is put into practical use. This can prevent the contamination of the exposed surface of the adhesive layer due to contact with external during usual handling.

### [Characteristic of Infrared Reflecting Film]

In the infrared reflecting film of the present invention, a normal emittance measured from the transparent protective layer 30 side is preferably 0.20 or less, more preferably 0.15 or less, further preferably 0.12 or less, and particularly preferably 0.10 or less. The normal emittance can be measured according to JIS R 3106-2008 (Testing method on transmittance, reflectance and emittance of flat glasses and evaluation of solar heat gain coefficient). The change in the emissivity of the infrared reflecting film immersed in a 5 wt% aqueous solution of sodium chloride for 5 days is preferably 0.02 or less, and more preferably 0.01 or less. The visible light transmittance of the infrared reflecting film is preferably 63% or more, more preferably 65% or more, further preferably 67% or more, and particularly preferably 68% or more. In the present invention, it is possible to manufacture, at a high level of productivity, an infrared reflecting film having the above-mentioned visible light transmittance, normal emittance and durability by depositing ZTO as the metal oxide layer constituting the infrared reflecting layer 20.

### [Usage]

The infrared reflecting film of the present invention is preferably used for being bonded to windows of buildings, vehicles or the like, transparent cases for botanical companions or the like, or showcases of freezing or cold storage, to improve the effects of cooling /heating and to prevent rapid changes in temperature. As schematically shown in FIG. 2, the infrared reflecting film 100 of the present invention transmits visible light (VIS) from the outdoors to introduce the light to the interior, and reflects near-infrared rays (NIR) from the outdoors at the infrared reflecting layer 20. Since heat flow from the outdoors to the interior resulting from sunlight is suppressed (heat shielding effect is exerted) by the reflection of near-infrared rays, efficiency of the air conditioning in summer can be increased. Moreover, when a material having low far-infrared ray absorption is used as the transparent protective layer 30, indoor far-infrared rays (FIR) emitted from a heating appliance 80 is reflected toward an indoor by the infrared reflecting layer 20, and thereby a heat insulating effect is exerted and efficiency of heating in winter can be increased.

### EXAMPLE

The present invention will be described more specifically below by showing examples, but the present invention is not limited to these examples.

### [Measuring Methods Used in Examples and Comparative Examples]

### <Thickness of Each Layer>

A thickness of each layer constituting the infrared reflecting layer was determined by machining a sample by a focused ion beam (FIB) method using a focused ion beam machining observation device (manufactured by Hitachi, Ltd., trade name "FB-2100"), and observing a cross-section of the sample using a field emission transmission electron microscope (manufactured by Hitachi, Ltd., trade name "HF-2000"). Thicknesses of the hard coat layer and the transparent protective layer formed on the substrate were determined by calculation from an interference pattern of reflected light of visible light in allowing light to enter from a measuring object side by using an instantaneous multi-photometric system (manufactured by Otsuka Electronics Co., Ltd., trade name "MCPD3000"). When the thickness of the transparent protective layer is small and observation of an interference pattern of visible light region is difficult (thickness about 150 nm or less), the thickness was determined from the observation by a transmission electron microscope as with each layer of the infrared reflecting layer described above.

### <Volume Resistivity of Target>

Surface resistance ρs(Ω/sq) at the target surface was measured using a resistivity meter (manufactured by Mitsubishi Chemical Analytech Co., Ltd., trade name "Loresta"), and volume resistivity pv was calculated from a product of surface resistance ps and the thickness.

### <Number of Occurrence of Abnormal Discharge>

The number of times of abnormal discharge was checked by monitoring a value indicated by an arc counter equipped in a DC power source (manufactured by HUTTINGER Elektronik GmbH, trade name "TruPlasma DC3010"), and reading an instantaneous voltage drop at the time of occurrence of abnormal discharge.

### <Normal Emittance>

Infrared rays were irradiated from the protective layer side using a Fourier transform infrared spectrophotometer (FT-IR) (manufactured by Varian Inc.) equipped with angle-variable accessories, and the normal reflectance of infrared rays in a wavelength range of 5 µm to 25 µm was measured, and then the normal emittance was determined according to JIS R 3106-2008 (Testing method on transmittance, reflectance and emittance of flat glasses and evaluation of solar heat gain coefficient).

### <Visible Light Transmittance >

The visible light transmittance was determined according to JIS A 5759-2008 (Adhesive films for glazings), by using a spectral photometer (trade name "U-4100" manufactured by Hitachi High-Technologies Corporation).

### <Salt Water Resistance Test>

A surface on a transparent film substrate side of an infrared reflecting film was bonded to a glass plate with a size of 3 cm x 3 cm with a pressure sensitive adhesive layer having a thickness of 25 µm interposed therebetween to form a sample to be used for a test. This sample was immersed in a 5 wt% aqueous solution of sodium chloride, a container containing the sample and the aqueous solution of sodium chloride was placed in a drier at 50°C, and changes in emissivity and changes in appearance were checked 5 days later and 10 days later and rated according the following criteria.
A: After 10 days immersion, there was no change in the appearance and change in the emissivity was 0.02 or less
B: After 5 days immersion, there is no change in the appearance and change in the emissivity is 0.02 or less, but after 10 days immersion, change in the appearance was found
C: After 5 days immersion, change in the appearance was found, and change in the emissivity was 0.02 or more

### [Example 1]

### (Formation of Hard Coat Layer on Substrate)

An acryl-based ultraviolet-curable hard coat layer (manufactured by Nippon Soda Co., Ltd., NH2000G) was formed in a thickness of 2 µm on one surface of a polyethylene terephthalate film (manufactured by Toray Industries Inc., trade name "Lumirror U48", visible light transmittance 93%) having a thickness of 50 µm. Specifically, a hard coat solution was applied with a gravure coater, dried at 80°C, and irradiated with ultraviolet rays of accumulated light quantity of 300 mJ/cm² by an ultra high pressure mercury lamp to be cured.

### (Formation of Infrared Reflecting Layer)

An infrared reflecting layer was formed on a hard coat layer of the polyethylene terephthalate film substrate by using a roll-to-roll sputtering apparatus. Specifically, by a DC magnetron sputtering method, a first metal oxide layer composed of a zinc-tin composite oxide (ZTO) and having a thickness of 30 nm, a metal layer composed of an Ag-Pd alloy and having a thickness of 15 nm, and a second metal oxide layer composed of ZTO and having a thickness of 30 nm were formed sequentially. A target formed by sintering composition consisting of zinc oxide, tin oxide and a metal zinc powder at a weight ratio of 16 : 82 : 2 was used for forming the ZTO metal oxide layers, and sputtering was performed under conditions of a power density: 2.67 W/cm², and a substrate temperature: 80°C. In this case, the amount of gas introduced into the sputtering chamber was adjusted so that a ratio between Ar and O₂ is 98 : 2 (volume ratio). A metal target containing silver and palladium in a weight ratio of 96.4 : 3.6 was used for forming the metal layer.

In this Example, continuous sputtering deposition was performed over a length of 200 m (6000 nm • m, in terms of a product of a thickness and a length of the metal oxide layer) in a direction of winding. Powder that causes abnormal discharge was not generated during sputtering, and deposition could be continuously performed stably without cleaning the target and the sputtering apparatus.

### (Formation of Transparent Protective Layer)

On the infrared reflecting layer, a protective layer composed of a fluorine-based ultraviolet-curable resin having a cross-linked structure derived from a phosphate ester compound, was formed in a thickness of 60 nm. Specifically, a solution prepared by adding 5 parts by weight of a phosphate ester compound (manufactured by Nippon Kayaku Co., Ltd., trade name "KAYAMER PM-21") to 100 parts by weight of a solid content of a fluorine-based hard coat resin solution (manufactured by JSR Corporation, trade name "JUA204"), was applied by using an applicator, dried at 60°C for 1 minute, and irradiated with ultraviolet rays of accumulated light quantity of 400 mJ/cm² by an ultra high pressure mercury lamp in a nitrogen atmosphere to be cured. The phosphate ester compound used here is a mixture of a phosphate monoester compound (compound represented by the formula (1), wherein X is a methyl group, n = 0, and p = 1) having one acryloyl group in a molecule and a phosphate diester compound (compound represented by the formula (1), wherein X is a methyl group, n = 0, and p = 2) having two acryloyl groups in a molecule.

The visible light transmittance of the infrared reflecting film prepared as described above was 70.1%.

### [Examples 2 to 7]

In Examples 2 to 7 described below, infrared reflecting films were prepared in the same manner as in Example 1 except for changing the composition of the target for depositing the metal oxide layer. In these Examples, as with Example 1, any metal oxide layer did not produce powder that causes abnormal discharge during sputtering, and stable deposition could be continuously performed stably over 6000 nm•m in terms of a product of a thickness and a length of the metal oxide layer without cleaning the target and the sputtering apparatus.

### [Example 2]

As the sputtering target for forming the metal oxide layers, a target formed by sintering composition consisting of zinc oxide, tin oxide, and a metal zinc powder at a weight ratio of 14 : 82 : 4 was used. The visible light transmittance of the infrared reflecting film was 69.8 %.

### [Example 3]

As the sputtering target for forming the metal oxide layers, a target formed by sintering composition consisting of zinc oxide, tin oxide, and a metal zinc powder at a weight ratio of 7 : 83 : 10 was used. The visible light transmittance of the infrared reflecting film was 68.6 %.

### [Example 4]

As the sputtering target for forming the metal oxide layers, a target formed by sintering composition consisting of zinc oxide, tin oxide, and a metal zinc powder at a weight ratio of 25.5: 66.5 : 8 was used. The visible light transmittance of the infrared reflecting film was 69.5 %.

### [Example 5]

As the sputtering target for forming the metal oxide layers, a target formed by sintering composition without containing zinc oxide, and consisting of tin oxide and a metal zinc powder at a weight ratio of 85 : 15, was used. The visible light transmittance of the infrared reflecting film was 67.7 %.

### [Example 6]

As the sputtering target for forming the metal oxide layers, a target formed by sintering composition without containing zinc oxide, and consisting of tin oxide and a metal zinc powder at a weight ratio of 92 :8, was used. The visible light transmittance of the infrared reflecting film was 68.2 %.

### [Example 7]

As the sputtering target for forming the metal oxide layers, a target formed by sintering composition consisting of zinc oxide, tin oxide, and a metal tin powder at a weight ratio of 19 : 73 : 8 was used. The visible light transmittance of the infrared reflecting film was 67.5 %.

### [Example 8]

In the formation of the metal layer, a metal target containing silver and gold at a weight ratio of 90 : 10 in place of an Ag-Pd alloy, was used to form a metal layer composed of an Ag-Au alloy. In the same manner as in Example 3 except for this, an infrared reflecting film was prepared.

### [Comparative Example 1]

As the sputtering target for forming the metal oxide layers, a target formed by sintering composition without containing metal powder, and consisting of zinc oxide and tin oxide at a weight ratio of 19 : 81, was used. Under the same conditions as in Example 1 except for this, sputtering deposition was tried, but discharge at a DC power source did not occur and a metal oxide layer could not be deposited.

### [Comparative Example 2]

As the sputtering target for forming the metal oxide layer, a target formed by sintering composition without containing metal powder and consisting of zinc oxide and tin oxide at a weight ratio of 90 : 10, was used. In the same manner as in Example 1 except for this, an infrared reflecting film was prepared. The depositing property of continuous sputtering was good as with Example 1, but the visible light transmittance of the infrared reflecting film was 60.1% and was significantly lower than Examples described above. Further, the durability (salt water resistance) of the infrared reflecting film was also deteriorated.

### [Comparative Example 3]

As the sputtering target for forming the metal oxide layers, a target formed by sintering composition without containing both zinc oxide and metal zinc powder, and consisting of tin oxide and metal tin at a weight ratio of 92 : 8, was used. Under the same conditions as in Example 1 except for this, sputtering deposition was tried, but discharge at a DC power source did not occur and a metal oxide layer could not be deposited.

### [Comparative Example 4]

In Comparative Example 4, indium tin oxide (ITO) layers were respectively deposited in a thickness of 40 nm in place of ZTO as the first metal oxide layer and the second metal oxide layer. A target formed by sintering indium oxide and tin oxide at a weight ratio of 90 : 10 was used for deposition of the ITO. Sputtering deposition was performed under the same conditions as in Example 1 except for this, and consequently occurrence of abnormal discharge was confirmed from the time when deposition was continuously performed up to a length of 25 m (1000 nm•m, in terms of the product of a thickness and a length of the metal oxide layer) in a direction of winding. After the metal oxide layer of a length of 6000 nm•m was continuously deposited, the target surface was checked, and consequently adhesion of the particles that caused abnormal discharge was confirmed.

### [Comparative Example 5]

In Comparative Example 4, indium zinc oxides (IZO) layers were respectively deposited in a thickness of 40 nm in place of ZTO as the first metal oxide layer and the second metal oxide layer. A target formed by sintering indium oxide and zinc oxide at a weight ratio of 90 : 10, was used for deposition of the IZO. Sputtering deposition was performed under the same conditions as in Example 1 except for this, and consequently occurrence of abnormal discharge was confirmed from the time when deposition was continuously performed up to a length of 50 m (2000 nm • m, in terms of the product of a thickness and a length of the metal oxide layer) in a direction of winding. After the metal oxide layer of a length of 6000 nm•m was continuously deposited, the target surface was checked, and consequently adhesion of the particles that caused abnormal discharge was confirmed.

### [Evaluation]

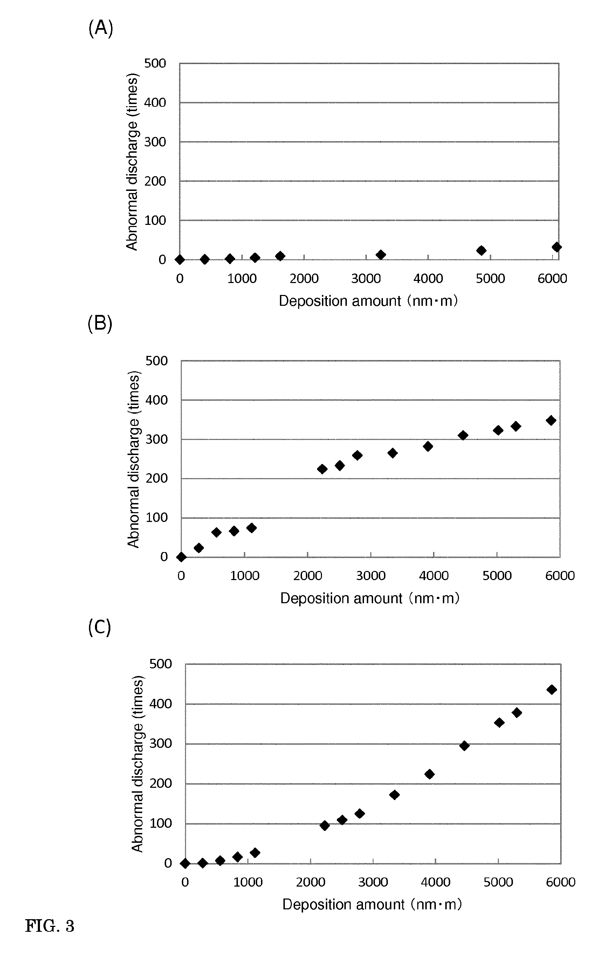

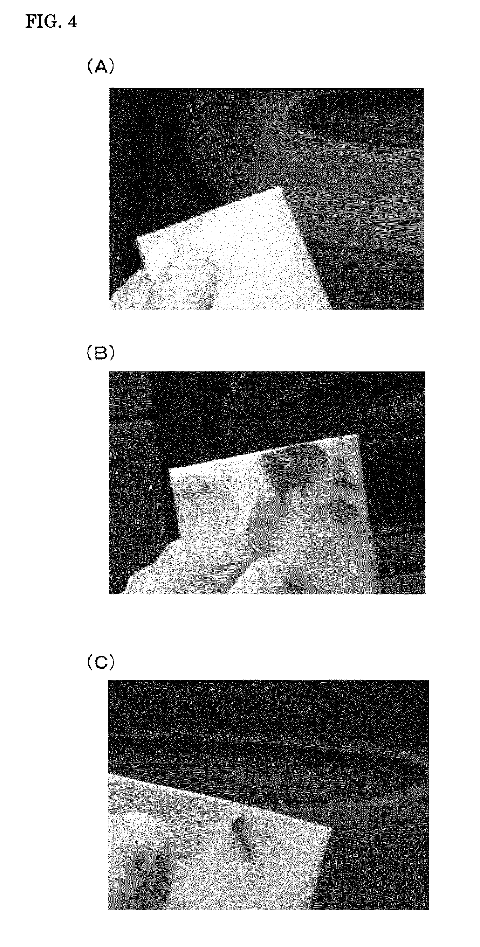

Table 1 are shows material of the metal oxide layer, material composition of the target used for deposition of the metal oxide layer, and evaluation results of the infrared reflecting film of each of Examples and Comparative Examples. FIGS. 3 (A) to (C) are graphs showing number of times of abnormal discharge occurred during metal oxide layer deposition, plotted with respect to the deposition amount. FIGS. 4 (A) to (C) are photographs showing a state of particle adhesion to the target surface in wiping the target surface after the metal oxide layer was continuously deposited over a length of 6000 nm • m. In FIG. 3 and FIG. 4, (A), (B) and (C) represent the number of times of abnormal discharge and a state of particle adhesion of Example 2 (ZTO), Comparative Example 4 (ITO) and Comparative Example 5 (IZO), respectively.

**[Table 1]**

| | metal oxide layer | | | | | | infrared reflecting film | |
|---|---|---|---|---|---|---|---|---|
| | material | target | | | continues process over 6000 nm • m | | salt water resistance | emissivity |
| | | composition (weight ratio) | metallic atom content ratio (atomic ratio) | volume resistivity (mQ·cm) | number of abnormal discharge | particle generation | | |
| Example 1 | ZTO | ZnO : SnO₂ : Zn = 16 : 82 : 2 | Zn :Sn = 30 : 70 | 316 | 52 | not confirmed | B | 0.07 |
| Example 2 | ZTO | ZnO : SnO₂ : Zn = 14 : 82 : 4 | Zn : Sn = 30 : 70 | 158 | 32 | not confirmed | A | 0.07 |
| Example 3 | ZTO | ZnO : SnO₂ : Zn = 7 : 83 : 10 | Zn : Sn = 30 : 70 | 63.2 | 29 | not confirmed | A | 0.07 |
| Example 4 | ZTO | ZnO : SnO₂ : Zn = 25.5 : 66.5: 8 | Zn: Sn = 50 : 50 | 18 | 15 | not confirmed | B | 0.06 |
| Example 5 | ZTO | ZnO : SnO₂ : Zn = 0 : 85 : 15 | Zn: Sn = 29 : 71 | 39.5 | 35 | not confirmed | A | 0.07 |
| Example 6 | ZTO | ZnO : SnO₂ : Zn = 0 : 92 : 8 | Zn : Sn =17 : 83 | 380 | 59 | not confirmed | A | 0.07 |
| Example 7 | ZTO | ZnO : SnO₂ : Sn = 19 : 73 : 8 | Zn: Sn = 30 : 70 | 130 | 45 | not confirmed | A | 0.07 |
| Example 8 | ZTO | ZnO : SnO₂ : Zn = 7 : 83 : 10 | Zn: Sn = 30 : 70 | 63.2 | 31 | not confirmed | A | 0.06 |
| Comparative Example 1 | ZTO | ZnO : SnO₂ = 19 : 81 | Zn : Sn = 30 : 70 | 52000 | no discharge | | - | |
| Comparative Example 2 | ZnO | ZnO : SnO₂ : Zn = 90 : 0 : 10 | Zn = 100 | 23 | 25 | not confirmed | C | 0.06 |
| Comparative Example 3 | SnO₂ | ZnO : SnO₂ : Sn = 0 : 92 : 8 | Sn = 100 | 46900 | no discharge | | - | |
| Comparative Example 4 | ITO | In₂O₃: SnO₂ = 90 : 10 | In : Sn = 91 : 9 | 0.12 | 348 | generated large amount | C | 0.06 |
| Comparative Example 5 | IZO | In₂O₃: ZnO = 90 : 10 | In:Zn=84:16 | 0.12 | 436 | generated large amount | C | 0.06 |

As is apparent from FIG. 3 and FIG. 4, it was found that in Comparative Example 4 and Comparative Example 5 in which ITO and IZO were deposited as the metal oxide layer, particles adhered to the surface of the target and the abnormal discharge occurred at the frequency some ten times larger than that of each Example, therefore the metal oxide layer is inferior in a continuously depositing property. Further, in the infrared reflecting substrates of Comparative Example 4 and Comparative Example 5, which include ITO and IZO as metal oxide layers, the infrared reflecting layers after the salt water resistance test were deteriorated heavily, and changes in appearance and rise in emissivity were confirmed.

In Comparative Example 2 in which ZnO was deposited as the metal oxide layer, adhesion of the powder to the target surface was not confirmed, but the visible light transmittance of the resulting infrared reflecting film was low and the durability was also low. On the other hand, in Comparative Example 3 in which the tin oxide target not containing zinc atoms was used, deposition by DC sputtering could not be performed since the resistance of the target was large. Also in Comparative Example 1 in which the ZTO target formed by sintering only a metal oxide was used, deposition by DC sputtering could not be performed since the resistance of the target was large.

In contrast with these results, in Examples 1 to 8 in which the target formed by sintering zinc oxide and/or tin oxide and a metal powder was used, there was no adhesion of the particles to the target, and the infrared reflecting films having a high visible light transmittance and excellent durability were obtained.

In Examples 1 to 3 and Example 7, the contents of zinc atoms and tin atoms, respectively contained in the target, is 30 : 70 in terms of an atomic ratio, as with Comparative Example 1. The electrical conductivity of the target in these Examples was largely improved, and long deposition could be performed without causing abnormal discharge by DC sputtering. Further, similar results were obtained in Example 8 in which the Ag-Au alloy was formed in place of the Ag-Pd alloy as the metal layer. In Examples 1 to 3, there were tendencies that the electrical conductivity of the target was improved and the durability was also improved with an increase of the metal content in the target material. On the other hand, there were tendencies that with the increase of the metal content, the visible light transmittance decreases. It is estimated from these results that a remaining metal or a metal oxide having insufficient oxygen exists in the metal oxide layer deposited by using a target formed by sintering a metal oxide and a metal powder, and affects the film characteristics such as durability as well as the sputtering deposition properties.

In a comparison between Example 3 and Example 4, there were tendencies that with the increase of the contents of zinc atoms, the durability of the infrared reflecting film was deteriorated. According to this result, it was found that the tin-rich ZTO is preferably deposited as the metal oxide layer from the viewpoint of increasing the durability of the infrared reflecting film. In a comparison between Examples 2 and 3 in which the target contains zinc as a metal powder and Example 7 in which the target contains tin as a metal powder, it is noted that a target containing zinc has lower in volume resistivity (higher in electrical conductivity) and exhibits higher visible light transmittance than a target containing tin, when the metal content is same. It can be said from this result that performing sputtering deposition using a target containing metal zinc as a target material is particularly preferable in the present invention.

As is apparent from a comparison between Comparative Example 2 and Comparative Example 3, tin oxide is lower in the electrical conductivity than zinc oxide, and in general, it is difficult to deposit a tin-rich ZTO by DC sputtering. On the other hand, as shown in each of Examples described above, it was found that in the present invention, by using a target formed by sintering a metal oxide and a metal powder, a tin-rich ZTO having excellent durability can be deposited at a high level of productivity by DC sputtering.

### DESCRIPTION OF REFERENCE CHARACTERS

100: infrared reflecting film
10: transparent film substrate
20: infrared reflecting layer
21, 22: metal oxide layer
25: metal layer
30: protective layer
60: adhesive layer

## Claims

1. A method for manufacturing an infrared reflecting film, the infrared reflecting film including: an infrared reflecting layer having a metal layer and a metal oxide layer; and a transparent protective layer, in this order on a transparent film substrate, wherein
the metal oxide layer is deposited by a DC sputtering method using a roll-to-roll sputtering apparatus,
a sputtering target used in the DC sputtering method contains zinc atoms and tin atoms, and
the sputtering target is a target formed by sintering a metal powder and at least one metal oxide among zinc oxide and tin oxide.

2. The method for manufacturing an infrared reflecting film according to claim 1, wherein a metal powder used for a formation of the sputtering target contains metal zinc or metal tin.

3. The method for manufacturing an infrared reflecting film according to claim 2, wherein a total of contents of the metal zinc and the metal tin used for the formation of the sputtering target is 0.1 to 20 wt%.

4. The method for manufacturing an infrared reflecting film according to any one of claims 1 to 3, wherein a ratio between zinc atoms and tin atoms, respectively contained in the sputtering target is in a range of 10 : 90 to 60 : 40 in terms of an atomic ratio.

5. The method for manufacturing an infrared reflecting film according to any one of claims 1 to 4, wherein deposition of the metal oxide layer is continuously performed to 6000 nm • m or more in terms of the product of a deposition thickness and a length.
